# EUROPEAN PATENT APPLICATION

(11) **EP 1 844 850 A1**
(43) Date of publication of application: **17.10.2007**
(21) Application number: 07251586.9
(22) Date of filing: 13.04.2007
(51) Int. Cl.: B01J 3/00, B08B 7/00, H01L 21/00

(54) **Cleaning of contaminated articles by aqueous supercritical oxidation**

(30) Priority: 13.04.2006 US 403749
(71) Applicant: Air Products and Chemicals, Inc., Allentown, PA 18195-1501 (US)
(72) Inventor: Mcdermott, Wayne Thomas, Fogelsville PA 18051 (US)
(74) Representative: Muir, Benjamin M. J.

(57) **Abstract**

Contaminant material is removed from a contaminated article by contacting the contaminated article with a reactive cleaning fluid comprising water and an oxidant material at a temperature at or above the critical temperature of the reactive cleaning fluid and a pressure at or above the critical pressure of the reactive cleaning fluid. At least a portion of the contaminant material is oxidized to yield a cleaned article and a product mixture comprising unreacted reactive cleaning fluid and removed contaminant material, and the product mixture is then separated from the cleaned article. Suitable oxidant materials include oxygen, ozone, hydrogen peroxide, chlorine, nitric oxide, nitrous oxide, nitrogen dioxide, nitrogen trifluoride, fluorine, and chlorine trifluoride.

## Description

### BACKGROUND OF THE INVENTION

Microelectronic circuit manufacture requires many processing steps that must performed under extremely clean conditions. Because the amount of contamination needed to produce fatal defects in microcircuits is extremely small, periodic cleaning of the wafers used for microelectronic circuits is needed to maintain economical yields. Also, tight control of purity and cleanliness of the processing materials is required.

Small quantities of contamination are detrimental to the microchip fabrication process. Contamination in the form of particulates, films, molecules, and ionic contaminants causes short circuits, open circuits, silicon crystal stacking faults, and other defects. These defects can cause the finished microelectronic circuit to fail, and such failures are responsible for significant yield reductions in the microelectronics industry. Yield reductions caused by microcontamination substantially increase processing costs.

In one widely-used integrated circuit (IC) fabrication process, thin photoresist layers are applied to sensitive semiconductor surfaces as part of a photolithographic process. These thin layers are subjected to baking, exposure, and rinsing to produce microscopic patterns on the semiconductor surface. The polymeric photoresist becomes cross-linked and strongly adheres to the surface during these processes, and these hardened sacrificial layers must be removed following subsequent etching or implantation processes. Known photoresist removal methods include wet chemical immersion and oxidation by plasma ashing. However, these wet chemical bath photoresist stripping and dry (plasma) photoresist ashing processes suffer from a number of limitations.

Wet chemical processing methods present increasing disadvantages as circuit dimensions are reduced and as environmental restrictions increase. Among the limitations of wet chemical processing are the high cost and purity requirements of cleaning agents, progressive contamination of recirculated liquids, re-deposition from contaminated chemicals, special disposal requirements, environmental damage, special safety procedures during handling, reduced effectiveness in deeply patterned surfaces due to surface tension effects and image collapse (topography sensitivity), dependence of cleaning effectiveness on surface wet-ability to prevent re-adhesion of contaminants, and possible liquid residue causing adhesion of remaining particles. Wet cleaning agents that depend upon chemical reaction with surface contaminants may also present compatibility problems with new thin film materials or with more corrosion-prone metals such as copper. With the continuing trend toward increasing wafer diameters having a larger precision surface area, a larger volume of liquid chemicals is required to complete the fabrication process. Also, wet chemical baths are traditionally wafer batch processes, which are inherently incompatible with new, single wafer processing tools.

Although plasma ashing overcomes most of the above limitations of chemical immersion, such plasmas require vacuum processing, associated high maintenance vacuum equipment, and vent stream abatement of hazardous and environmentally damaging substances. Plasmas tend to leave residual contamination ("veils" or "fences") on the substrate surface, tend to produce large concentrations of suspended particulate matter in the reactor, and can cause radiation damage to the circuits from the high energy plasma field. Such damage requires generation of the reactive plasma at a location removed from the wafer, thereby reducing the efficiency of the process. Plasma ashing also is ineffective in removing metallic ions and therefore may require subsequent liquid immersion treatment for metallic ion removal.

Numerous attempts have been made to effect dry (anhydrous) and/or chemical-free surface cleaning of semiconductor substrates. These methods provide alternatives to conventional liquid-, vapor-, and plasma-phase processing, and include (1) optical methods such as laser ablation and laser-induced levitation of particles, (2) gas jets, (3) UV/ozone, (4) aerosol jets, and (5) immersion in supercritical fluid (SCF) or liquid CO₂ with the optional use of ultrasonic energy. Supercritical fluids can be used to strip the photoresist without prior ashing and/or remove the photoresist ash residue from surfaces following a conventional ashing processes, such as plasma ashing. In either case, chemically reactive additives and co-solvent materials may be added to the CO₂ as a means to enhance removal of the unwanted surface layer or post-ash residue. Such methods are broadly referred to as post-etch, or post-ash supercritical CO₂ (SCCO₂) wafer cleaning. CO₂ is typically used due to its low cost, lack of toxicity, environmental compatibility and low critical temperature (31.3 °C).

Future micro-electronic circuits will have smaller feature sizes and greater complexity, and the manufacture of these circuits will require more processing steps. Decreased dimensions between circuit features will become increasingly sensitive to damage by contamination. In order to maintain economical yields, therefore, improved wafer cleaning procedures and contamination control techniques will be needed in the manufacturing process to meet these increasingly stringent requirements. This need is addressed by embodiments of the present invention as described below and defined in the claims that follow.

### BRIEF SUMMARY OF THE INVENTION

One embodiment of the invention includes a method for removing contaminant material from a contaminated article comprising contacting the contaminated article with a reactive cleaning fluid containing water and an oxidant material at a temperature at or above the critical temperature of the reactive cleaning fluid and a pressure at or above the critical pressure of the reactive cleaning fluid, oxidizing at least a portion of the contaminant material to yield a cleaned article and a product mixture comprising unreacted reactive cleaning fluid and removed contaminant material, and separating the product mixture from the cleaned article.

Another embodiment of the invention relates to an oxidation process for removing contaminant material from a contaminated article including (a) providing a contaminated article comprising an article with contaminant material adhering to at least a portion thereof; (b) placing the contaminated article in an oxidation vessel; (c) contacting the contaminated article with a reactive cleaning fluid comprising water and an oxidant material at a temperature at or above the critical temperature of the reactive cleaning fluid and a pressure at or above the critical pressure of the reactive cleaning fluid; (d) oxidizing at least a portion of the contaminant material to yield a cleaned article and a product mixture comprising unreacted reactive cleaning fluid and removed contaminant material; (e) separating the product mixture from the cleaned article; and (f) removing the cleaned article from the oxidation vessel.

A related embodiment of the invention includes a system for removing contaminant material from a contaminated article comprising
(a) an oxidation vessel including sealable closure for introducing a contaminated article into the vessel and removing a cleaned article from the vessel;
(b) a water storage vessel;
(c) an oxidant storage vessel;
(d) a mixing device for mixing the water and the oxidant to provide a reactive cleaning fluid;
(e) a pressurizing device for pressurizing the reactive cleaning fluid to provide the reactive cleaning fluid in the oxidation reactor at a pressure at or above the critical pressure of the reactive cleaning fluid, a heater for heating at least a portion of the reactive cleaning fluid to a temperature at or above the critical temperature of the reactive cleaning fluid, and a support for contacting the reactive cleaning fluid with the contaminated article in the oxidation reactor; and
(f) lines for introducing fluid into the oxidation vessel and for withdrawing therefrom a product mixture comprising unreacted reactive cleaning fluid and removed contaminant material.

Another related embodiment of the invention includes a system for removing contaminant material from a contaminated article comprising
(a) an oxidation vessel including sealable closure for introducing a contaminated article into the vessel and removing a cleaned article from the vessel;
(b) a reactive cleaning fluid storage vessel;
(c) an oxidant storage vessel;
(d) lines for transferring the oxidant from the oxidant storage vessel to the reactive cleaning fluid storage vessel and lines for providing water to the reactive cleaning fluid storage vessel, wherein the oxidant and water can mix to provide the reactive cleaning fluid in the reactive cleaning fluid storage vessel;
(e) a pressurizing device for pressurizing the reactive cleaning fluid to provide the reactive cleaning fluid in the oxidation reactor at a pressure at or above the critical pressure of the reactive cleaning fluid, a heater for heating at least a portion of the reactive cleaning fluid to a temperature at or above the critical temperature of the reactive cleaning fluid, and a support for contacting the reactive cleaning fluid with the contaminated article in the oxidation reactor; and
(f) an inlet for introducing fluid into the oxidation vessel and for an outlet for withdrawing therefrom a product mixture comprising unreacted reactive cleaning fluid and removed contaminant material.

### BRIEF DESCRIPTION OF SEVERAL VIEWS OF THE DRAWINGS

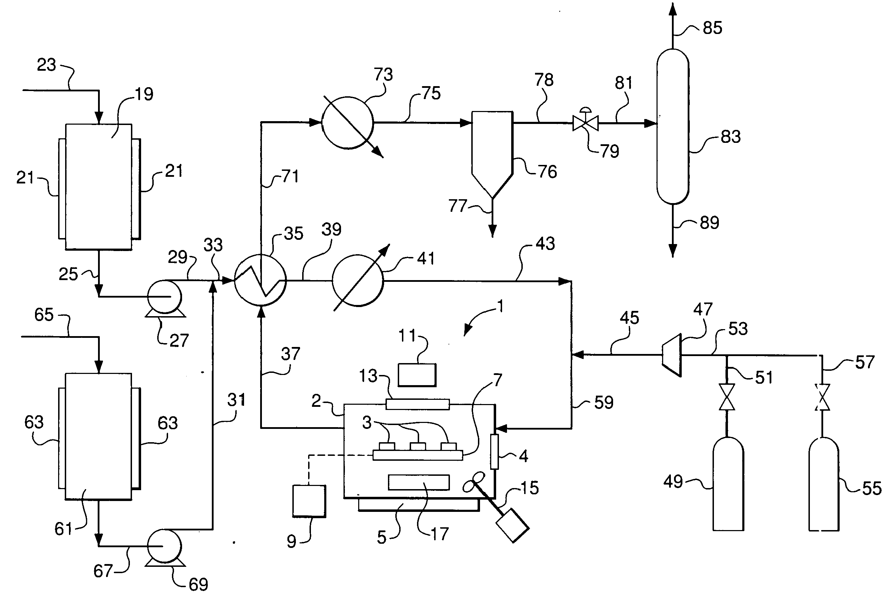

The single Figure is a schematic flow diagram of an embodiment of the present invention.

### DETAILED DESCRIPTION OF THE INVENTION

The embodiments of the invention provide methods for removing contaminant material from a contaminated article by contacting the article with a reactive cleaning fluid comprising water and an oxidant material at a temperature at or above the critical temperature of the reactive cleaning fluid and a pressure at or above the critical pressure of the reactive cleaning fluid. At least a portion of the contaminant material is oxidized at these conditions to yield a cleaned article and a product mixture comprising unreacted reactive cleaning fluid and removed contaminant material, and the product mixture is separated from the cleaned article. The product mixture may be processed to remove the oxidized contaminants, and the remaining water may be purified for recycle to make fresh reactive cleaning fluid.

The methods described below may be used advantageously for the cleaning of semiconductor components and other articles in the electronics industry. These components and articles may include, for example, silicon or gallium arsenide wafers, reticles, photomasks, flat panel displays, internal surfaces of processing chambers, printed circuit boards, surface mounted assemblies, electronic assemblies, wafer processing system components, electro-optical, laser and spacecraft hardware, and surface micro-machined systems. Any other articles having oxidizable contaminants also may be cleaned by these methods. The contaminant material may comprise one or more components selected from exposed photoresist material, photoresist residue, UV-or X-ray-hardened photoresist, C-F-containing polymers, organic etch residues, inorganic etch residues, ionic metal-containing compounds, neutral metal-containing compounds, and post-planarization particles.

An oxidant material is defined herein as any element or compound in an aqueous reactive cleaning fluid that can oxidize contaminant material on a contaminated article to a degree sufficient to remove the contaminant material from the surface of the article. The oxidant material may include one or more components selected from oxygen, ozone, hydrogen peroxide, chlorine, nitric oxide, nitrous oxide, nitrogen dioxide, nitrogen trifluoride, fluorine, and chlorine trifluoride.

The term "contaminant material" is defined as any material adhering to the surface of a contaminated article wherein the adhering material is undesirable and prohibits the use of the article for its intended purpose. The term "removed contaminant material" is defined as any material in any form that is present in the product mixture separated from the cleaned article that was not present in the reactive cleaning fluid prior to contact with the contaminated article. Some or all of the contaminant material may be oxidized to yield the removed contaminant material. The term "cleaned article" means the resulting article after removal of a desired amount of contaminant material from the contaminated article.

A reactive cleaning fluid is defined as a multicomponent mixture of water and one or more oxidant materials. The critical temperature and the critical pressure of a reactive cleaning fluid of a given composition are defined by any combination of temperature and pressure above which the reactive cleaning fluid can exist only as a single phase. The critical pressure of the reactive cleaning fluid is that pressure above which no phase change will occur when the temperature is changed and the critical temperature of the reactive cleaning fluid is that temperature above which no phase change will occur when the pressure is changed. The critical temperature and critical pressure of the reactive cleaning fluid depend on the composition of the fluid. As the concentration of the oxidant materials decreases, the critical temperature and pressure of the reactive cleaning fluid approach the critical temperature and critical pressure of water, i.e., 374°C and 218.3 atma (3,208 psia, 22.12 MPa). The term "aqueous" as applied to the cleaning fluids described herein means that the cleaning fluids contain water in any form.

The indefinite articles "a" and "an" as used herein mean one or more when applied to any feature in embodiments of the present invention described in the specification and claims. The use of "a" and "an" does not limit the meaning to a single feature unless such a limit is specifically stated. The definite article "the" preceding singular or plural nouns or noun phrases denotes a particular specified feature or particular specified features and may have a singular or plural connotation depending upon the context in which it is used The adjective "any" means one, some, or all indiscriminately of whatever quantity. The term "and/or" placed between a first entity and a second entity means one of (1) the first entity, (2) the second entity, and (3) the first entity and the second entity.

During cleaning, the contacting of the contaminated article with the reactive cleaning fluid may be enhanced by ultrasonic energy. The oxidant material may be provided onsite, for example, by an oxygen generator or by an ozone generator that produces ozone from air or high purity oxygen. Typically, the oxidant in the reactive cleaning fluid is provided in an amount that is 1 to 100 times the stoichiometric amount required to oxidize the contaminant material to form oxidized contaminants in the removed contaminant material.

After initial oxidative cleaning, a cleaned article may be cleaned further with a secondary cleaning fluid in a second cleaning step to remove any residual material from the surface of the article. The second cleaning step may be effected at a temperature at or above the critical temperature of the secondary cleaning fluid and a pressure at or above the critical pressure of the secondary cleaning fluid.

The secondary cleaning fluid may comprise one or more components selected from carbon dioxide, ammonia, hydrogen fluoride, hydrogen chloride, nitrous oxide, nitrogen trifluoride, nitrogen, oxygen, ozone, argon, helium, hydrogen, fluoroform, methane, hydrocarbons having 2 to 6 carbon atoms, sulfur hexafluoride, sulfur trioxide, monofluoromethane, difluoromethane, trifluoromethane, trifluoroethane, tetrafluoroethane, hexafluoroethane, pentafluoroethane, perfluoropropane, pentafluoropropane, and tetrafluorochloroethane, or mixtures thereof. The secondary cleaning fluid may contain one or more cleaning agents selected from acetylenic alcohols, acetylenic diols, non-ionic alkoxylated acetylenic diol surfactants, self-emulsifiable acetylenic diol surfactants, siloxane polymers, silicone-based surfactants, silicone-based defoamers, alcohols, tertiary alkyl amines, quaternary alkyl amines, tertiary alkyl diamines, quaternary alkyl diamines, amides, alkyl alkanolamines, chelating agents, trifluoroacetic anhydride (TFAA), halogenated carboxylic acids, halogenated glycols, halogenated alkanes, and halogenated ketones.

The initial cleaning step and the second cleaning step may be carried out in the same cleaning system as described below, thereby minimizing the necessary handling of the articles being cleaned. The reactive cleaning fluid andior the secondary cieaning fluid may be heated and pressurized to a temperature and pressure above the critical temperature and pressure of the respective cleaning fluid prior to or following introduction into the cleaning chamber. Supercritical pressures may be attained by mechanical devices using pumps or compressors to transfer the fluid from storage into the cleaning chamber. Alternatively, supercritical pressures may be attained by heating the fluid to a supercritical temperature at constant volume and density in a vessel external to the cleaning chamber and transferring the heated and pressurized fluid into the cleaning chamber at final conditions that are above the critical temperature and pressure of the fluid. In another alternative, the cleaning fluid may be introduced into the cleaning chamber at subcritical conditions and then heated therein at constant volume and density to a supercritical temperature and pressure.

In one embodiment, highly effective cleaning may be realized using oxygen as the oxidant with water to form the reactive cleaning fluid. The oxidation reactions initiate spontaneously under supercritical conditions and are exothermic, thereby producing a self-sustaining reaction that generates sufficient heat to maintain the process until the contaminants are nearly completely oxidized. The low viscosity and high diffusivity of this aqueous supercritical reactive cleaning fluid permits high mass transfer rates of contaminants into the fluid. High contaminant destruction efficiencies up to of 99.99% are possible. The dielectric constant of the aqueous reactive cleaning fluid decreases to values below 2 at supercritical conditions, and this increases the solubility of organic contaminant materials in the fluid, including organic materials containing halogens such as chlorine, fluorine and bromine. These contaminant materials are brought into intimate contact with the aqueous reactive cleaning fluid and are rapidly converted by oxidation into CO₂, water, and other products. Polar contaminants are also readily oxidized, dissolved, and carried away by the aqueous reactive cleaning fluid. Nitrogen-, chlorine-, and sulfur-containing compounds are converted into nitrogen gas and/or into mineral acids and neutralized in inorganic salts that are entirely dissolved in the reactive cleaning fluid.

Typical harmless waste products that are generated in the process include clean water, CO₂, some alkali salts, some metal oxides and insoluble salts, inorganic acids, and trivial amounts of N₂ and O₂. The reaction does not produce harmful nitrogen oxides or sulfur oxides because the oxidation reactions occur at much lower temperatures than those required for incineration

Embodiments of the invention include and utilize the cleaning system illustrated by the schematic process flow diagram of the single Figure. Oxidation reactor 1 comprises pressure vessel 2 having a sealable closure 4 for placing contaminated articles 3 into the vessel and for removing the articles after cleaning is complete. The oxidation vessel has at least one inlet for introducing a reactive cleaning fluid into the vessel and at least one outlet for withdrawing spent cleaning fluid, i.e., a product mixture containing removed contaminant material and unreacted reactive cleaning fluid. The vessel may be heated as required by heater 5, shown here as placed on the vessel wall. Alternatively, an internal heater (not shown) may be located within the vessel to heat the internal fluid directly. The oxidation vessel is designed to operate at pressures up to 700 atma (70 MPa) and temperatures up to 500°C.

Contaminated articles 3 are placed on support substrate 7, which may be heated by optional electrical resistance heating or by induction heating that is controlled by heater controller 9. The heated support substrate may be used to heat articles 3 by direct conduction and may provide some heat to the reactive cleaning fluid adjacent the surfaces of the substrate and articles. Alternatively or additionally, articles 3 and the reactive cleaning fluid adjacent the surfaces of the articles may be heated by infrared radiant heater 11 that transmits heating radiation to articles 3 via window 13 installed in a wall of oxidation vessel 1.

Agitator 15 may be used to circulate fluid within the vessel during the cleaning process. Alternatively or additionally, ultrasonic generator 17 may be used to generate ultrasonic energy that enhances the cleaning process.

The cleaning system includes storage vessel 19 for storing ultra-pure water used for the reactive cleaning fluid. The storage vessel may be a pressure vessel capable of operation up to 700 atma (70 MPa) and may be fitted with heaters 21 capable of heating the vessel to a temperature up to 500 °C. Makeup water is added via line 23, process water exits via line 25, and optional pump 27 is used to transfer previously-pressurized and heated water to the oxidation vessel. Alternatively, optional pump or metering pump 27 may be used to pressurize water stored at low pressure in water storage vessel 19. Pump 27 may not be needed when the water is pressurized in water storage vessel 19 by isochoric heating at constant density and volume as described below.

Pump discharge line 29 is joined by optional line 31 containing a secondary cleaning fluid as described below. Line 33 leads to heat exchanger 35, which heats the fluid in line 33 by indirect heat exchange with spent reactive cleaning fluid in line 37 from oxidation reactor 1. Line 39 from heat exchanger 35 leads to optional heater 41 for additional heating of the reactive cleaning fluid, and line 43 from the heat exchanger is joined by line 45 from compressor 47. Oxidant gas for the reactive cleaning fluid is provided by oxidant cylinder 49 via line 51 and manifold 53 to compressor 47. Optional secondary cleaning gas cylinder 55 is joined via line 57 to manifold 53. Line 59 provides reactive cleaning fluid and optional secondary cleaning fluid to oxidation reactor 1.

The cleaning system may include secondary cleaning fluid storage vessel 61 for storing a secondary cleaning fluid component. This storage vessel may be a pressure vessel capable of operation up to 700 atma (70 MPa) and may be fitted with heaters 63 capable of heating the vessel to 500 °C. Makeup secondary cleaning fluid is added via line 65 and the secondary fluid exits via line 67. Optional pump or metering pump 69 may be used to transfer previously-pressurized and heated secondary cleaning fluid to the oxidation vessel via line 31. Alternatively, optional pump 69 may be used to pressurize and pump the secondary cleaning fluid stored at low pressure in storage vessel 61. Pump 69 may not be needed when the secondary cleaning fluid is pressurized in storage vessel 61 by isochoric heating at constant density and volume as described below.

Line 71 connects the outlet of heat exchanger 35 with cooler 73 and line 75 connects the outlet of cooler 73 with solids separator 76. This solids separator may utilize sedimentation, filtration, inertial separation, or any other known solid-liquid separation process. Solid contaminants may be withdrawn from separator 76 via line 77. Line 78 connects the outlet of separator 76 with pressure reduction valve 79, and line 81 connects the valve to the inlet of vapor-liquid separator vessel 83. This separator vessel is fitted with vapor outlet 85 and liquid outlet 89.

The cleaning process is initiated by opening pressure vessel 2, placing contaminated articles 3 on support substrate 7, and closing and sealing the pressure vessel. Cleaning may be effected under flow conditions in which the reactive cleaning fluid is passed continuously through the oxidation vessel, thereby providing a continuous flushing process to sweep the removed contaminant material until cleaning is complete. Alternatively, cleaning may be effected under non-flow conditions in which the reactive cleaning fluid is charged into pressure vessel 2, the vessel is isolated until cleaning is complete or nearly complete, and the vessel is flushed to complete the process. In other operating alternatives, any combination of flow and non-flow periods may be used.

The contaminant material on the contaminated articles reacts with the oxidant material in the reactant cleaning fluid such that at least a portion of the contaminant material is oxidized to form oxidation products which are separated from the article and are dissolved in or suspended in the cleaning fluid. Some of the contaminant material may be separated from the surface of the article by the oxidation of a portion of the contaminant material. Some of the removed contaminant material thus may be in the form of oxidation products and some may be in the form of suspended removed contaminant material that has not been completely oxidized.

During the cleaning process, the reactive cleaning fluid in contact with the articles is maintained at a temperature at or above the critical temperature of the reactive cleaning fluid and a pressure at or above the critical pressure of the reactive cleaning fluid. The supercritical conditions of the reactive cleaning fluid in pressure vessel 2 may be achieved by any of several operating methods using mechanical pressurization by pump 27 and/or compressor 47, by constant volume (isochoric) and constant density (isopycnic) heating in water storage vessel 19 and/or in pressure vessel 2, or by combinations thereof. The contact time between the contaminated articles and the reactive cleaning fluid may be between 1 and 600 seconds.

In one embodiment, ultra-pure water is isolated in water storage vessel 19 and heated isochorically and isopycnically therein to a selected supercritical temperature and supercritical pressure. The supercritical water is transferred via lines 25, 29, 33, 39, 43, and 59 into oxidation reactor 1 without the use of pump 27 so that the water in oxidation reactor 1 is above the critical temperature and critical pressure of water after transfer. Oxidant gas from oxidant cylinder 49 is pressurized and transferred by compressor 47 into oxidation reactor 1 to form the reactive cleaning fluid at a temperature and pressure therein above the critical temperature and critical pressure of the reactive cleaning fluid. This embodiment eliminates the need for transfer pump 27, thereby reducing equipment capital and operating costs and the potential for water contamination by defective pump seals.

In another embodiment, subcritical water from water storage vessel 19 and subcritical oxidant gas from oxidant cylinder 49 are transferred into pressure vessel 2 to form the reactive cleaning fluid at subcritical conditions. Pressure vessel 2 is isolated and heated isochorically and isopycnically by heater 5 to a temperature and pressure therein above the critical temperature and critical pressure of the reactive cleaning fluid.

In an alternative embodiment, subcritical water from water storage vessel 19 is pumped to a supercritical pressure by pump 27, heated by heat exchanger 35 and/or heater 41 to a supercritical temperature, and introduced into pressure vessel 2. Oxidant gas from oxidant cylinder 49 is compressed by compressor 47 to a pressure above the pressure in oxidation reactor 1 without removing the heat of compression and the hot compressed oxidant gas is introduced into oxidation reactor 1 to form the reactive cleaning fluid. The pressures and temperatures of the water and oxidant gas transfer steps are selected so that the final reactive cleaning fluid in pressure vessel 2 is above the critical temperature and critical pressure of the reactive cleaning fluid.

In another alternative embodiment, the reactive cleaning fluid is provided to oxidation reactor 1 by pumping the water and compressing the oxidant gas into pressure vessel 2 to form the reactive cleaning fluid at a pressure above its critical pressure and a temperature below its critical temperature. Contaminated articles 3 are heated to a selected temperature such that the reactive cleaning fluid adjacent and in contact with the surfaces of the articles is heated to a temperature above the critical temperature of the cleaning fluid. The remaining cleaning fluid in the oxidation reactor remains below the critical temperature of the reactive cleaning fluid. This embodiment speeds the cleaning process and reduces the energy consumption of the process.

In yet another embodiment, oxidant gas storage tank 49 is connected to water storage vessel 19 by piping (not shown) and the proper amount of oxidant gas is introduced into the vessel with the proper amount of ultra-pure water. Water storage vessel 19 then is isolated and heated isochorically and isopycnically to increase the temperature and pressure of the reactive cleaning fluid formed therein to a selected supercritical temperature and supercritical pressure. The supercritical reactive cleaning fluid is transferred via lines 25, 29, 33, 39, 43, and 59 into oxidation reactor 1 without the use of pump 27 so that the reactive cleaning fluid in oxidation reactor 1 after transfer is above the critical temperature and critical pressure of the reactive cleaning fluid. This embodiment eliminates the need for transfer pump 27 and compressor 47, thereby reducing equipment capital and operating costs and the potential for water and gas contamination by defective pump and compressor seals.

Other combinations of ultra-pure water pumping, oxidant gas compression, heating in water storage vessel 19, heating by heat exchanger 35 and heater 41, and heating in oxidation reactor 1 can be envisioned to provide the required reactive cleaning fluid at supercritical conditions for contact with the contaminated articles. For example, a selected amount of oxidant gas can be introduced into pressure vessel 2 at subcritical conditions, ultra-pure water can be isolated in water storage vessel 19 and heated isochorically and isopycnically therein to a selected supercritical temperature and supercritical pressure, and the supercritical water can be transferred into pressure vessel 2, thereby forming the reactive cleaning fluid at supercritical conditions. In this example, compressor 47 would not be needed.

In a specific alternative, hydrogen peroxide can be mixed with ultra-pure water in vessel 19 to form a subcritical reactive cleaning fluid that is stored in vessel 19, and this subcritical reactive cleaning fluid can be heated and/or pressurized by any of the methods described above to conditions above its critical temperature and pressure.

In a typical example of a representative cleaning process, contaminated silicon wafers 3 containing residual photoresist material are placed on support substrate 7 in pressure vessel 2, and the pressure vessel is closed and sealed. Ultra-pure water is introduced via line 23 into water storage vessel 19 in an amount sufficient to clean the articles during the duration of the cleaning step. The water is optionally preheated therein, pressurized by pump 27 to a selected pressure above 218.3 atma (22.12 MPa), transferred via lines 33 and 39, heated to a temperature above 374°C in heater 41, and transferred via lines 43 and 59 into pressure vessel 2, thereby initially heating and pressurizing the vessel to a temperature and pressure above the water critical temperature and pressure. High purity oxygen from cylinder 49 is compressed by compressor 47 and introduced via lines 45 and 59 into pressure vessel 2 at the required pressure, thereby providing the oxidant for the reactive cleaning fluid. Flow at the desired flow rate is continued by pump 27, and the flow of oxygen at the required rate is continued by compressor 47.

The reactive cleaning fluid is formed in pressure vessel 2 and is maintained above its critical temperature and pressure as it flows through the vessel. The fluid is mixed by agitator 15 within the vessel, cleans the articles therein by oxidative reactions with the photoresist material, and spent cleaning fluid is withdrawn via line 37. The spent cleaning fluid is cooled in heat exchanger 35 by indirect heat exchange with incoming water from line 33, thereby heating the water, and flows via line 71 to cooler 73, where it is cooled to near-ambient temperature. The cooled spent cleaning fluid, now a multiphase mixture liquid containing water and one or more of soluble alkali salts, metal oxides, insoluble salts, inorganic acids, carbon dioxide, and small amounts of dissolved N₂ and O₂, passes through solids separator 76 to remove suspended solids. The spent cleaning fluid continues into vapor-liquid separator vessel 83, where the remaining gaseous components are withdrawn via vapor outlet 85 and the water containing soluble components is withdrawn via liquid outlet 89. This water stream may be further processed for re-use by known methods such as deionization, reverse osmosis, and ultrafiltration.

Water and oxygen flow are continued to provide a constant flow of the reactive cleaning fluid through pressure vessel 2 at the desired conditions for a time period sufficient to clean the wafers. When the cleaning process with the reactive cleaning fluid is complete, the cleaned wafers may be cleaned further in a second cleaning step with a secondary cleaning fluid to remove any residual material from the articles. The second cleaning step may be effected at a temperature at or above the critical temperature of the secondary cleaning fluid and a pressure at or above the critical pressure of the secondary cleaning fluid. The secondary cleaning fluid may be provided by the same or similar steps as the reactive cleaning fluid of the initial cleaning step. The operation and control of the second cleaning step likewise may be carried out at similar conditions in a manner similar to that of the initial cleaning step. Components for the secondary cleaning fluid are provided from secondary cleaning fluid storage vessel 61 by pump 69 and secondary cleaning gas cylinder 55 by compressor 47.

### EXAMPLE

A 1 cm square silicon wafer sample containing exposed and cross-linked polymeric photoresist was placed in a 500 cm³ pressure resistant reaction vessel. The stainless steel vessel was then charged with high purity filtered water mixed with 1% by volume H₂O₂ at a temperature of 380°C and an initial pressure of 14.7 psia (101 kPa). At these conditions the water was in the vapor phase. Heating of the reactive cleaning fluid containing water and H₂O₂ was provided by resistance heaters located on the exterior of the reaction vessel and feed lines. Thermocouple temperature sensors on the heaters provided feedback to the electric temperature controller. A backpressure regulator was located downstream of the reaction vessel and was set at 3,300 psia (23 MPa) A high pressure piston-type pump was used to force the reactive cleaning fluid containing water and H₂O₂ into the reaction vessel. As the water/H₂O₂ mixture continuously entered the reaction vessel, the pressure of the reaction vessel was increased to 3,300 psia (23 MPa). As the pressure of the heated reactive cleaning fluid increased above 3,208 psia (22.12 MPa), it became a supercritical fluid inside the reaction vessel. After supercritical conditions were achieved, the flow of heated water/H₂O₂ mixture was provided by the pump through the vessel and pressure regulator at a flow rate of 10 actual cm³/minute. The system was held at 380°C and 3,300 psia (23 MPa) for 5 minutes as water and H₂O₂ flowed continuously through the vessel. The residual spent cleaning fluid then was vented from the vessel, the vessel was opened, and the silicon wafer sample was removed and rinsed in filtered high purity water. The rinsed wafer sample was dried by heating the wafer for 1 hour at 200°C in an oven purged with filtered N₂. The wafer was then examined under SEM, and it was seen that the photoresist and other contaminant materials were completely removed from the wafer surface.

## Claims

1. A method for removing contaminant material from a contaminated article comprising contacting the contaminated article with a reactive cleaning fluid comprising water and an oxidant material at a temperature at or above the critical temperature of the reactive cleaning fluid and a pressure al or above the critical pressure of the reactive cleaning fluid, oxidizing at least a portion of the contaminant material to yield a cleaned article and a product mixture comprising unreacted reactive cleaning fluid and removed contaminant material, and separating the product mixture from the cleaned article.

2. The method of Claim 1 comprising contacting the cleaned article with a secondary cleaning fluid to remove residual product mixture from the cleaned article to yield a further cleaned article.

3. An oxidation process for removing contaminant material from a contaminated article according to the method of claim 1, the process comprising
(i) placing in an oxidation vessel a contaminated article comprising an article with contaminant material adhering to at least a portion thereof;
(ii) contacting the contaminated article with a reactive cleaning fluid comprising water and an oxidant material at a temperature at or above the critical temperature of the reactive cleaning fluid and a pressure at or above the critical pressure of the reactive cleaning fluid;
(iii) oxidizing at least a portion of the contaminant material to yield a cleaned article and a product mixture comprising unreacted reactive cleaning fluid and removed contaminant material;
(iv) separating the product mixture from the cleaned article; and
(v) removing the cleaned article from the oxidation vessel.

4. The method of Claim 3 comprising providing the reactive cleaning fluid in a cleaning fluid preparation vessel at a temperature below the critical temperature of the reactive cleaning fluid and a pressure below the critical pressure of the reactive cleaning fluid, sealing the vessel, heating the vessel at constant volume to increase the temperature and pressure therein to a temperature above the critical temperature of the reactive cleaning fluid and a pressure above the critical pressure of the reactive cleaning fluid to form a supercritical cleaning fluid, placing the cleaning fluid preparation vessel in flow communication with the oxidation vessel, and transferring the supercritical cleaning fluid to the oxidation vessel for the contacting of the contaminated article with the reactive cleaning fluid at a temperature at or above the critical temperature of the reactive cleaning fluid and a pressure at or above the critical pressure of the reactive cleaning fluid.

5. The method of Claim 3 comprising introducing the reactive cleaning fluid into the oxidation vessel at a temperature below the critical temperature of the reactive cleaning fluid and a pressure below the critical pressure of the reactive cleaning fluid, sealing the oxidation vessel, heating the oxidation vessel to increase the temperature and pressure therein at constant volume to a temperature at or above the critical temperature of the reactive cleaning fluid and a pressure at or above the critical pressure of the reactive cleaning fluid, thereby contacting the contaminated article with the reactive cleaning fluid comprising water and an oxidant material at a temperature at or above the critical temperature of the reactive cleaning fluid and a pressure at or above the critical pressure of the reactive cleaning fluid.

6. The method of Claim 3 comprising introducing water and the oxidant material into the oxidation vessel to provide the reactive cleaning fluid at a temperature below the critical temperature of the reactive cleaning fluid and a pressure below the critical pressure of the reactive cleaning fluid, sealing the oxidation vessel, heating the oxidation vessel to increase the temperature and pressure therein at constant volume to a temperature at or above the critical temperature of the reactive cleaning fluid and a pressure at or above the critical pressure of the reactive cleaning fluid, thereby contacting the contaminated article with the reactive cleaning fluid at a temperature at or above the critical temperature of the reactive cleaning fluid and a pressure at or above the critical pressure of the reactive cleaning fluid.

7. The method of Claim 3 comprising pressurizing and heating water to a first temperature and pressure to form pressurized and heated water, pressurizing the oxidant material to the first pressure and mixing it with the pressurized and heated water to form the reactive cleaning fluid, and introducing the reactive cleaning fluid into the oxidation vessel containing the contaminated article such that the reactive cleaning fluid is at a temperature at or above the critical temperature of the reactive cleaning fluid and a pressure at or above the critical pressure of the reactive cleaning fluid.

8. The method of Claim 3 wherein the reactive cleaning fluid comprises a first portion that is adjacent the contaminated article and in contact with the contaminated article and a second portion that fills the remainder of the oxidation vessel, and wherein the contacting of the contaminated article with the reactive cleaning fluid comprises heating the contaminated article to a temperature such that the temperature of the first portion of the reactive cleaning fluid is at or above the critical temperature of the reactive cleaning fluid, and the temperature of the second portion of the reactive cleaning fluid is less than the temperature of the first portion of the reactive cleaning fluid.

9. The method of any one of Claims 3 to 8, wherein the contaminated article is heated by placing the contaminated article on a support substrate, heating the support substrate, and transferring heat to the contaminated article and wherein the support substrate is heated by a method selected from electrical resistance heating, electrical induction heating, and infrared radiation.

10. The method of any one of Claims 3 to 9, wherein ultrasonic energy is introduced into the oxidation vessel during at least a portion of the contacting of the contaminated article with the reactive cleaning fluid.

11. The method of any one of Claims 3 to 10, wherein following step (iv) and prior to step (v) the cleaned article in the oxidation vessel is contacted with a secondary cleaning fluid to remove residual product mixture from the cleaned article and yield a further cleaned article.

12. The method of Claim 2 or 11, wherein the secondary cleaning fluid comprises one or more components selected from carbon dioxide, ammonia, hydrogen fluoride, hydrogen chloride, nitrous oxide, nitrogen trifluoride, nitrogen, oxygen, ozone, argon, helium, hydrogen, fluoroform, methane, hydrocarbons having 2 to 6 carbon atoms, sulfur hexafluoride, sulfur trioxide, monofluoromethane, difluoromethane. trifluoromethane, trifluoroethane, tetrafluoroethane, hexafluoroethane, pentafluoroethane, perfluoropropane, pentafluoropropane, and tetrafluorochloroethane, or mixtures thereof.

13. The method of any one of Claims 2, 11, or 12, wherein the contacting of the cleaned article with the secondary cleaning fluid is effected at a temperature at or above the critical temperature of the secondary cleaning fluid and a pressure at or above the critical pressure of the secondary cleaning fluid.

14. The method of any preceding claim, wherein the oxidant material comprises one or more components selected from oxygen, ozone, hydrogen peroxide, chlorine, nitric oxide, nitrous oxide, nitrogen dioxide, nitrogen trifluoride, fluorine, and chlorine trifluoride.

15. The method of any preceding Claim, wherein the contacting of the contaminated article with the reactive cleaning fluid and/or the secondary cleaning fluid is enhanced by ultrasonic energy.

16. A system for removing contaminant material from a contaminated article comprising
(a) an oxidation vessel (2) including a sealable closure (4) for introducing a contaminated article (3) into the vessel and removing a cleaned article from the vessel;
(b) a water storage vessel (19);
(c) an oxidant storage vessel (49);
(d) a mixing device for mixing the water and the oxidant to provide a reactive cleaning fluid;
(e) a pressurizing device (27, 47) for pressurizing the reactive cleaning fluid to provide the reactive cleaning fluid in the oxidation vessel at a pressure at or above the critical pressure of the reactive cleaning fluid, a heater (5, 7, 11, 2 i, 35, 41) for heating at least a portion of the reactive cleaning fluid to a temperature at or above the critical temperature of the reactive cleaning fluid, and a support (7) for contacting the reactive cleaning fluid with the contaminated article in the oxidation reactor; and
(f) lines (59, 37) for introducing fluid into the oxidation vessel and for withdrawing therefrom a product mixture comprising unreacted reactive cleaning fluid and removed contaminant material.

17. The system of Claim 16 comprising a heater (5, 7, 11) for heating all or a portion of the reactive cleaning fluid in the oxidation vessel to a temperature at or above the critical temperature of the reactive cleaning fluid.

18. The system of Claim 16 or 17, comprising a heater for heating the contaminated article within the oxidation vessel, the heater being selected from
(1) a support substrate (7), heated by electrical resistance heating, for placement of the contaminated article on the substrate;
(2) a support substrate (7), heated by electrical induction heating, for placement of the contaminated article on the substrate; and
(3) an infrared radiant heater (11) disposed outside the oxidation vessel, and a pressure-resistant window (13) in the oxidation vessel that is transparent to infrared radiation generated by the radiant heater, wherein the radiant heater is disposed in the line of sight with the contaminated article.

19. The system of Claim 16, 17 or 18, comprising an ultrasonic generator (17) adapted to introduce ultrasonic energy into the oxidation vessel.

20. A system for removing contaminant material from a contaminated article comprising
(a) an oxidation vessel (2) including a sealable closure (4) for introducing a contaminated article (3) into the vessel and removing a cleaned article from the vessel;
(b) a reactive cleaning fluid storage vessel (19);
(c) an oxidant storage vessel (49);
(d) lines for transferring the oxidant from the oxidant storage vessel to the reactive cleaning fluid storage vessel and lines (23) for providing water to the reactive cleaning fluid storage vessel, wherein the oxidant and water can mix to provide the reactive cleaning fluid in the reactive cleaning fluid storage vessel;
(e) a pressurizing device (27, 47) for pressurizing the reactive cleaning fluid to provide the reactive cleaning fluid in the oxidation vessel at a pressure at or above the critical pressure of the reactive cleaning fluid, a heater (5, 7, 11, 21, 35, 41) for heating at least a portion of the reactive cleaning fluid to a temperature at or above the critical temperature of the reactive cleaning fluid, and a support (7) for contacting the reactive cleaning fluid with the contaminated article in the oxidation reactor; and
(f) an inlet (59) for introducing fluid into the oxidation vessel and an outlet (37) for withdrawing therefrom a product mixture comprising unreacted reactive cleaning fluid and removed contaminant material.
